# EUROPEAN PATENT APPLICATION

(11) **EP 2 579 158 A1**
(43) Date of publication of application: **10.04.2013**
(21) Application number: 10852153.5
(22) Date of filing: 27.05.2010
(51) Int. Cl.: G06F 12/02, G06F 12/06

(54) **MEMORY SYSTEM AND MEMORY INTERFACE DEVICE**

(71) Applicant: Fujitsu Limited, Kawasaki-shi, Kanagawa 211-8588 (JP)
(72) Inventor: KITAGO Keita, Kawasaki-shi, Kanagawa 211-8588 (JP); OWAKI Takeshi, Kawasaki-shi, Kanagawa 211-8588 (JP); ISHIZUKA Takaharu, Kawasaki-shi, Kanagawa 211-8588 (JP); KAWANO Hiroshi, Kawasaki-shi, Kanagawa 211-8588 (JP); MOROSAWA Atsushi, Kawasaki-shi, Kanagawa 211-8588 (JP)
(74) Representative: HOFFMANN EITLE
(86) International application number: PCT/JP2010/058972
(87) International publication number: WO 2011/148483

(57) **Abstract**

A memory access source (3) regards a plurality of memory circuits (DIMM 0, 1) as single memory circuit and transmits a row address and a column address in time division to an access control circuit (20). The access control circuit (20) performs a speculative access to the plurality of memory circuits (DIMM 0, 1) when receiving the row address, and performs an access to a memory circuit which is specified by the column address after receiving the column address and sends a cancel command of the speculative access to the other memory circuit out of target. Or, in the case of read access, the access control circuit (20) receives read data from the plurality of memory circuits and discards the read data of the memory circuit out of the target by the column address.

## Description

### TECNICAL FIELD

The embodiments discussed herein are related to memory system and a memory interface device.

### BACKGROUND ART

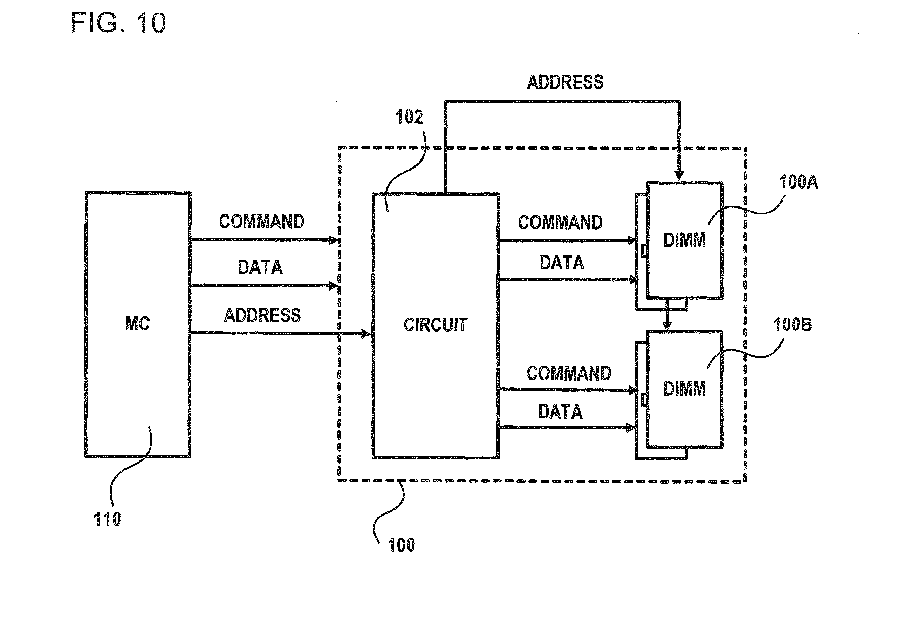

With a high-speed and a large-scale of the information processing apparatus, using existing interface signal, an increase in the storage capacity of memory is demanded. As depicted in FIG. 10, memory system 100 having memory circuits 100A and 100B and an interface circuit 102 has been proposed. A memory controller (hereinafter referred to as "MC") 110 in the system sends command (read/write command) and address to the memory system 100.

For example, the memory circuits 100A and 100B are composed of DIMM (Dual Inline Memory Module). The interface circuit 102 converts the received address, and outputs converted address to the memory circuits 100A and 100B. Thus, it is possible to virtually increase the capacity of the memory circuits (DIMM) which are connected to the system using the existing memory interface. Here, the system (the memory controller 110) can access two memory circuits (DIMM) 100A and 100B by the existing memory interface, so memory capacity is doubled.

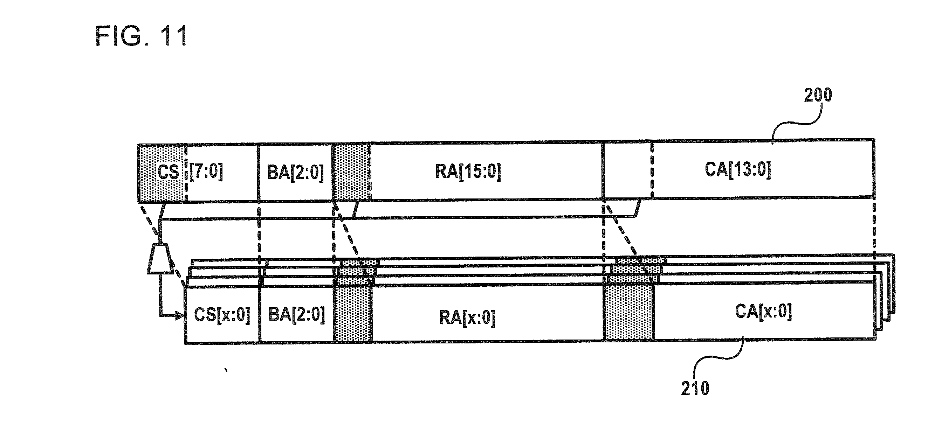

As the method of address conversion, a method that uses a portion of the address has been proposed. As depicted in FIG. 11, for example, a format of the memory address 200 of DDR (Double Data Rate) 3 includes a CS Chip Select of 8 bits [7:0] and a Bank Select (BS Bank Select) of 3 bits [2:0], a row address (RA) of 16 bits [15:0] and a column address (CA) of 14bits [13:0].

By specifications such as memory (DIMM) capacity and the number of banks, in the row address (RA) and the column address (CA), there are unused bits which are not utilized for memory access (indicated by the shaded area in FIG. 11). The interface circuit 102 converts the row and column address into memory address 210 that the row address and the column address are extended using the unused bits of memory address 200. In FIG. 11, a shaded portion in the memory address 200 indicates the extended address.

A plurality of memory circuits (DIMM) 100A and 100B connect to the memory controller 110 via the interface circuit 102. Thus, it is possible that the memory controller 110 virtually recognizes to connect single memory (DIMM) even though connecting to two memories actually. The memory system is called to virtual memory system.

### Prior art documents;

### Patent documents;

[Patent Document 1] United States Laid-open Patent Publication No. 2007-0192563;
[Patent Document 2] Japanese Laid-open Patent Publication No. 2008-077635;
[Patent Document 3] Japanese Laid-open Patent Publication No. Sho 62-252591;
[Patent Document 4] Japanese Laid-open Patent Publication No. 2001-167077.

### SUMMARY OF THE INVENTION

### PROBLEM TO BE SOLVED BY THE INVENTION

The memory which has a large capacity uses full of the memory address according to the large capacity. For example, when using a large capacity memory such as DIMM of 4Gb (Giga byte) = 512 Mb(Mega byte) x 8 bits, the unused bits are not present in the row address RA. For this reason, the address is converted to an address of the virtual memory system by using the unused bits [11:13] of the column address.

For example, when configuring the virtual DIMM of 8Gb by using two DIMM of 4Gb (512Mb x 8bit), it is determined which DIMM access by using the bit 11 of the column address CA. According, when constituting a large capacity memory circuit, by using a plurality of DIMM of which the capacity is more than 4Gb, for example, it is necessary to use the unused bits of the column address.

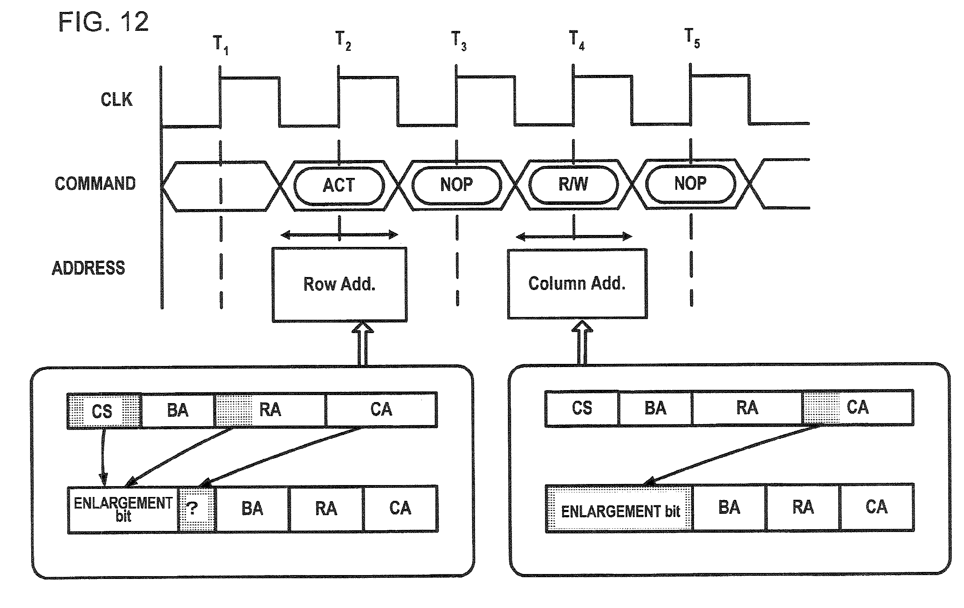

On the other hand, in memory of DDR/DDR2/DDR3 specification, the memory controller sends the row address (RA) and the column address (CA) in time division to the memory. As illustrated in FIG.12, the memory controller sends ACT command and the row address Row Add to the memory at time T2 and sends read/write (R/W) command and the column address Column Add to the memory at time T4. Note that the symbol "NOP" in the command indicates a not operation command.

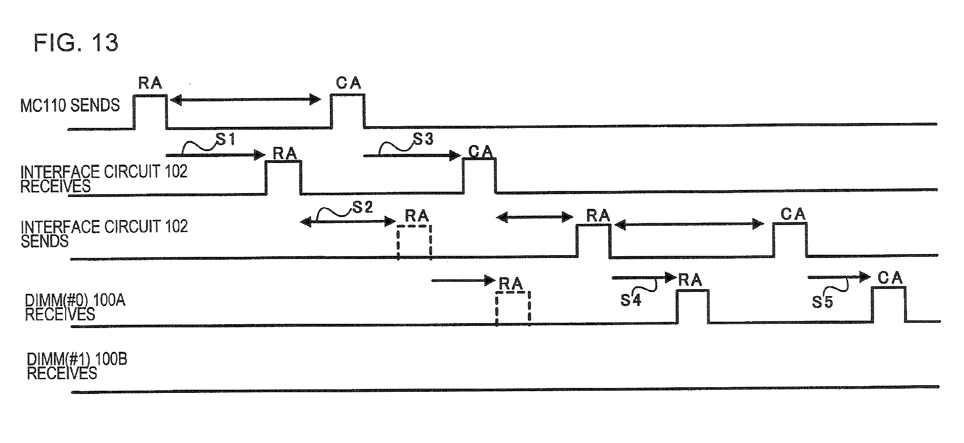

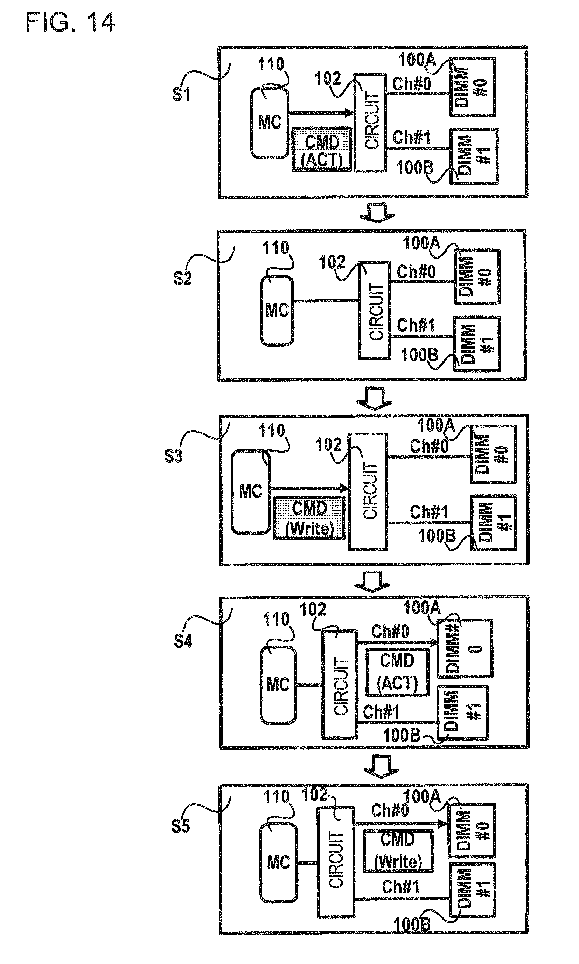

The memory access operation in the time division transmission as illustrated in FIG. 12 will be explained according to a time chart in FIG. 13, with reference to the operation explanatory diagram in FIG. 14. As illustrated in FIG. 13, the memory controller 110 sends the ACT command and the row address RA and the interface circuit 102 receives the row address RA (S1 in FIG.13 and FIG.14). In order that the interface circuit 102 performs virtual address conversion described above, it is necessary to receive the column address CA. Therefore, as indicated by dotted line in FIG. 13, the row address RA can not be output to the DIMM 100A (S2 in FIG. 13 and FIG. 14).

Then, the memory controller 110 sends the read/write command and the column address CA and the interface circuit 102 receives the column address CA (S3 in FIG. 13 and FIG. 14). Because the interface circuit 102 received the column address CA, the interface circuit 102 converts an address, and outputs the ACT command and the row address RA to the DIMM 100A (S4 in FIG. 13 and FIG.14).

Then, the interface circuit 102 outputs the read/write command and the column address CA to the DIMM 100A (S5 in FIG. 13 and FIG. 14). In addition, the distance between the row address RA and the column address CA is defined by the specification of the DDR.

As described above, in the system which identify the real DIMM by using the column address CA of the virtual DIMM, it is not possible to specify the DIMM of access target at the time when receives the row address RA. In other words, when the interface circuit has received the row address RA, the interface circuit can not issue the ACT command to the real DIMM. Therefore, it necessary that the interface circuit waits for the receipt of the column address CA in order to issue the ACT command. Therefore, the memory access latency is increased, the memory access performance becomes reduced.

Accordingly, it is an object in one aspect of the invention to provide memory system and a memory interface device to reduce memory access latency of the virtual memory system which is virtually recognized a plurality of memory as a single memory.

### MEANS FOR SOLVING THE PROBLEMS

According to an aspect of the embodiments, memory system includes a plurality of memory circuits and an access control circuit that receives row address and first command, then receives column address and second command from a memory access source, identifies a designated one memory circuit among the plurality of memory circuits from the column address, and controls an access of the designated one memory circuit, and the access control circuit performs a speculative access to the plurality of memory circuits when receiving the row address and the first command, and sends the second command to the designated one memory circuits and sends a third command that cancel the speculative access to other memory circuits that is not designated by the column address when receiving the column address and the second command.

Further, according to another aspect of the embodiments, memory system includes a plurality of memory circuits and an access control circuit that receives row address and first command, then receives column address and second command from a memory access source, identifies a designated one memory circuit among the plurality of memory circuits from the column address, and controls an access of the designated one memory circuit, and the access controls circuit performs a speculative access to the plurality of memory circuits when receiving the row address and the first command, and sends the second command to the plurality of memory circuits when receiving the column address and the second command and discards read data from the memory circuits which is not designated by the column address.

In addition, according to an aspect of the embodiments, an memory interface circuit includes an access control circuit that receives row address and first command, then receives column address and second command from a memory access source, identifies a designated one memory circuit among a plurality of memory circuits from the column address, and controls an access of the designated one memory circuit, and the access control circuit performs a speculative access to the plurality of memory circuits when receiving the row address and the first command, and sends the second command to the designated one memory circuits and sends a third command that cancel the speculative access to other memory circuits that is not designated by the column address when receiving the column address and the second command.

In addition, according to another aspect of the embodiments, a memory interface circuit includes an access control circuit that receives row address and first command, then receives column address and second command from a memory access source, identifies a designated one memory circuit among the plurality of memory circuits from the column address, and controls an access of the designated one memory circuit, and the access control circuit performs a speculative access to the plurality of memory circuits when receiving the row address and the first command, and sends the second command to the plurality of memory circuits when receiving the column address and the second command and discards read data from the memory circuits which is not designated by the column address.

### EFFECT OF THE INVENTION

An access control circuit, which receives the row address and the column address in time division and designates one among a plurality of memory circuits, performs a speculative access to the plurality of memory circuits when receiving the row address and accesses one memory circuit which is designated by the column address and sends a third command that cancel the speculative access to other memory circuits that is not designated by the column address when receiving the column address and the second command which outsets the speculative access to the memory circuit which is out of access target after receiving the column address. Therefore, because the memory circuit out of the access is controlled that was not accessed from the beginning, it is possible to reduce the delay (latency) of the memory access. In the case of a read access, because the read data from the designated memory circuit is received and the read data from the memory circuit which is not designated is discarded, it is possible to reduce the delay (latency) of memory access.

### BRIEF DESCRIPTION OF THE DRAWINGS

FIG. 1 is a block diagram of a memory system according to the embodiment;
FIG. 2 is a block diagram of a memory (DIMM) in FIG. 1;
FIG. 3 is a process flow diagram of access control according to a first embodiment of the access control circuit in FIG. 1;
FIG. 4 is a time chart of the process in FIG. 3;
FIG. 5 is an explanation diagram of a write operation in the process of FIG. 3.
FIG. 6 is an explanatory diagram of a read operation of the process of FIG. 3;
FIG. 7 is a process flow diagram of the access control according to a second embodiment of the access control circuit of FIG. 1;
FIG. 8 is a time chart of the processing of FIG. 7;
FIG. 9 is an explanatory diagram of a read operation of the process of FIG. 7;
FIG. 10 is an explanatory diagram of a conventional virtual memory system;
FIG. 11 is an explanation diagram of the operation of a conventional address conversion;
FIG. 12 is a time chart of the operation of the conventional memory access;
FIG. 13 is an explanation diagram of transfer of address and command in DDR3;
FIG. 14 is an explanatory diagram of a conventional memory access operation.

### EMBODIMENTS TO REALIZE THE INVENTION

Hereinafter, the embodiments will be described in the order of a first embodiment of the memory system, a second embodiment of the memory system and the other embodiments, but the disclosed memory system and the memory are not limited to these embodiments.

### (First embodiment of the memory system)

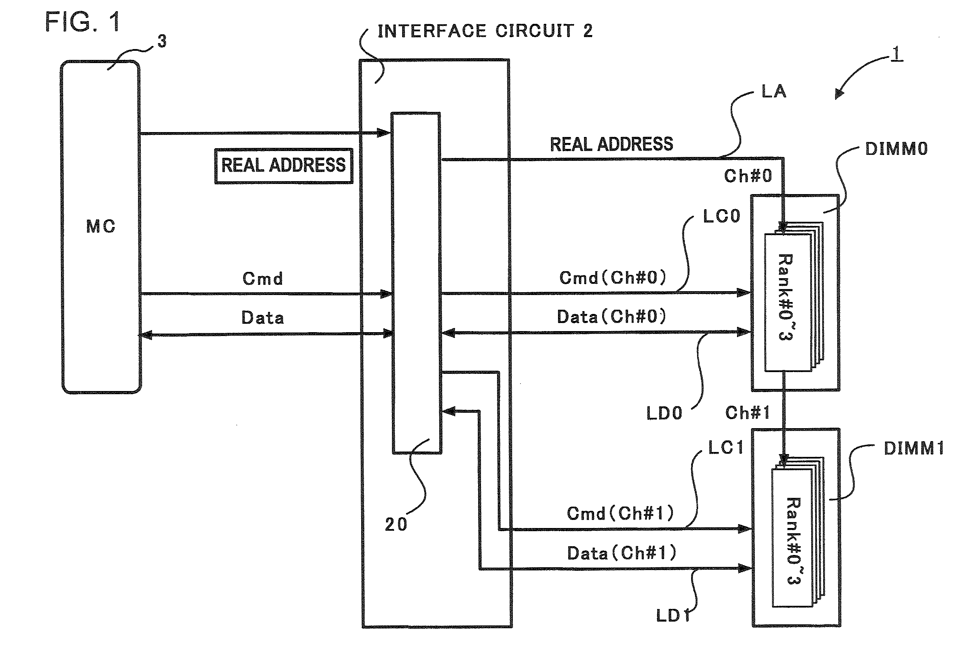

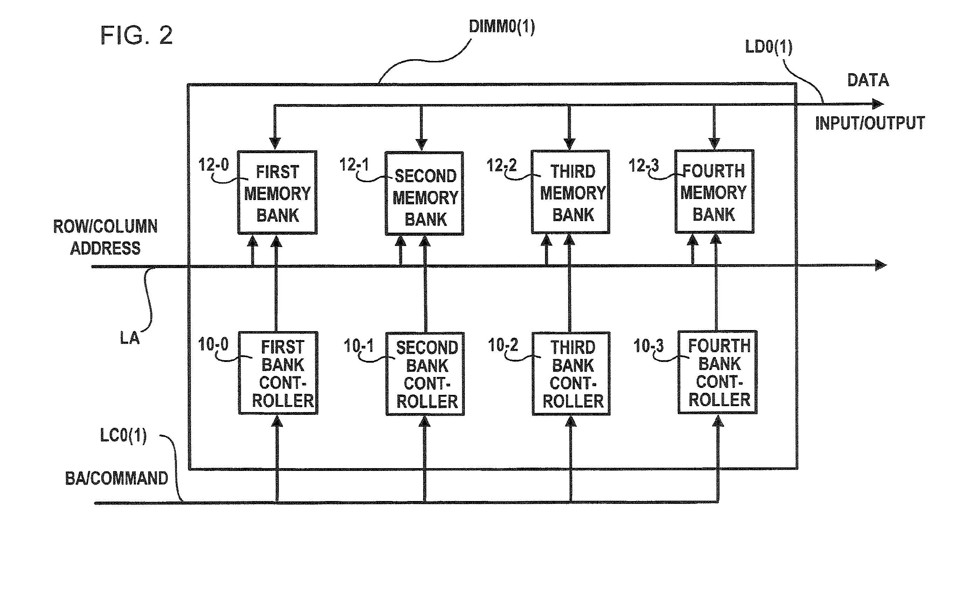

FIG. 1 is a block diagram of a memory system of the embodiment. FIG. 2 is a block diagram of a memory (DIMM) in FIG. 1. As illustrated in FIG. 1, the memory system includes an interface circuit 2 and a memory circuit 1. The memory circuit 1 has two memory modules DIMM0 and DIMM1. The two memory modules DIMM0 and DIMM1, for example, are composed of Dual Line Memory Module.

Each of two memory modules DIMM0 and DIMM1 has a plurality of banks #0 to #3 (also referred to as rank). And two memory modules DIMM0 and DIMM1 connect in daisy chain by address lines LA. The interface circuit 2 includes an access control circuit 20. The access control circuit 20 connects to a memory controller 3 and two memory modules DIMM0 and DIMM1. The access control circuit 20 receives real address, command Cmd and data Data from the memory controller 3.

The access control circuit 20 sends received the real address to the memory module DIMM0 via the address lines LA. Further, the access control circuit 20 connects to a first memory module DIMM0 through a command line LC0 and data line LC0 of a first channel Ch#0 and connects to a second memory module DIMM1 through a command line LC1 and data line LC of a second channel Ch#1.

Each of the memory modules will be explained by using FIG. 2. The memory module DIMM0 (1) includes a plurality of memory banks 12-0 ∼ 12-3 and a plurality of bank control circuits 10-0 ∼ 10-3. Since the number of bank memory is four in the example in FIG. 2, the memory module DIMM0 (1) has four bank memories 12-0 ∼ 12-3 and four bank control circuits 10-0 ∼ 10-3.

Each of the bank control circuits 10-0 ∼ 10-3 receives memory bank address BA and commands from the access control circuit 20 through the command line LC0(1) and allows an access of a memory bank 12-0 ∼ 12-3 which is designated by the bank address.

The memory banks receive a row address and a column address from the access control circuit 20 through the address line LA and select the memory address in the memory bank. Then, the memory banks 12-0 ∼ 12-3 performs read/write of contents in selected address depending on the bank select signal and the command from the bank control circuit 10-0 ∼ 10-3. Each of the memory banks 12-0 ∼ 12-3 outputs the read data and inputs the write data through the data lines LD0(1).

In the embodiment, the access control circuit 20 is composed of a microcontroller, for example. This access control circuit 20 performs a speculative access to all memory modules which has a possibility to be accessed. The access control circuit 20 performs the access to the memory module which is specified after receiving the column address. And the access control circuit 20 sends a command which outsets the speculative access to the memory circuit which is out of access target after receiving the column address. Therefore, the memory circuit out of the access is controlled that was not accessed from the beginning.

Even though the memory system identifies the real memory module by the column address CA, it is possible to reduce the delay (latency) of memory access.

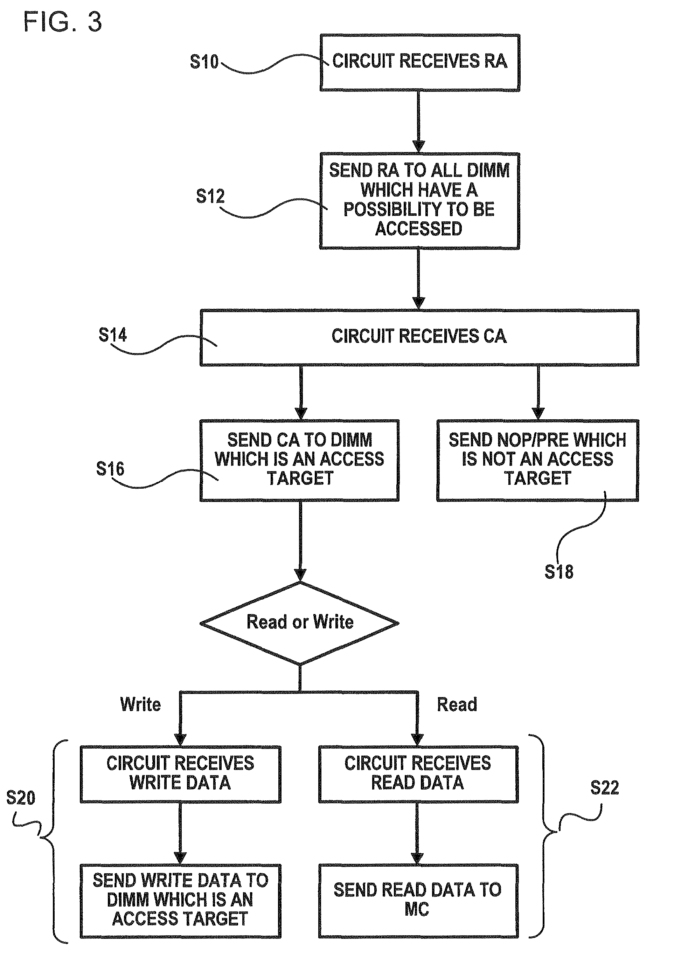

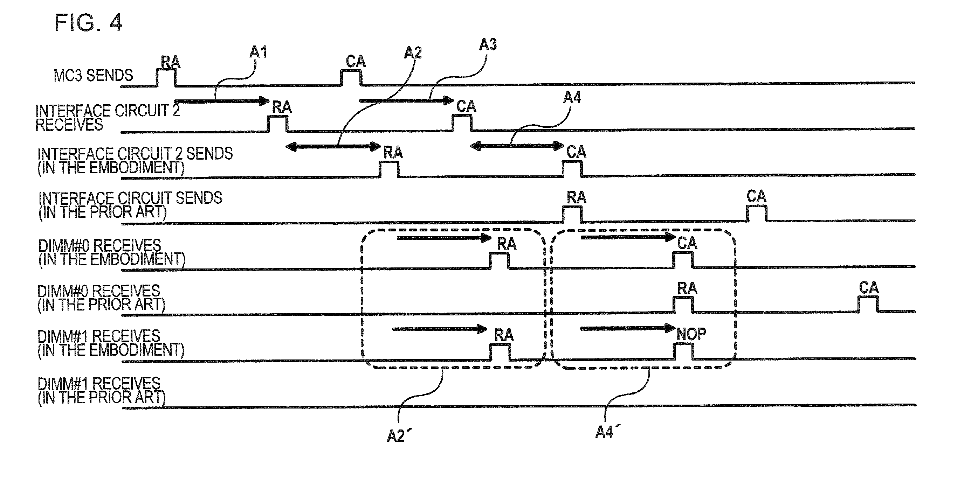

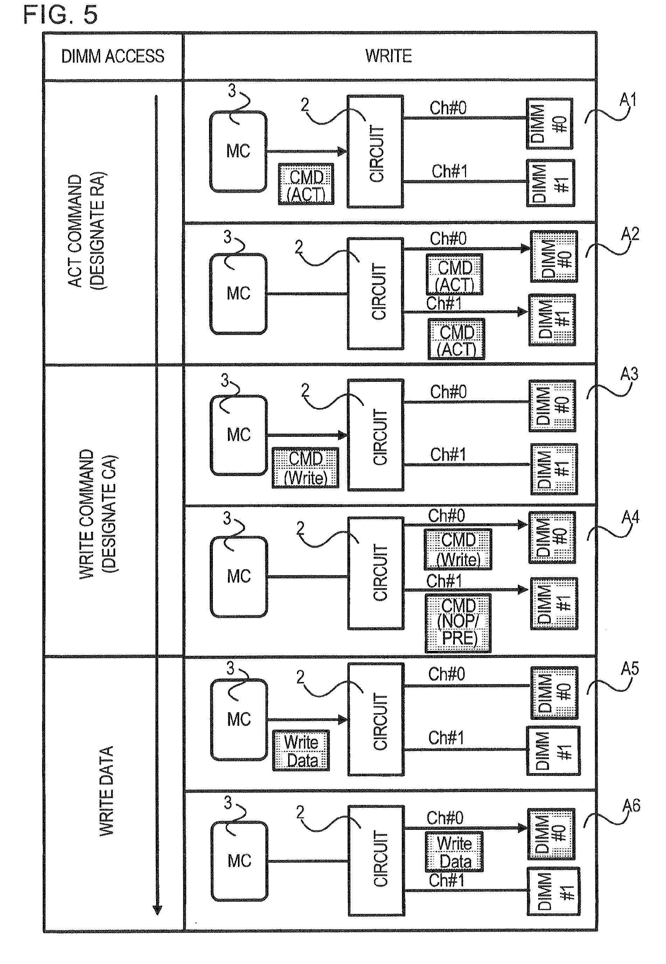

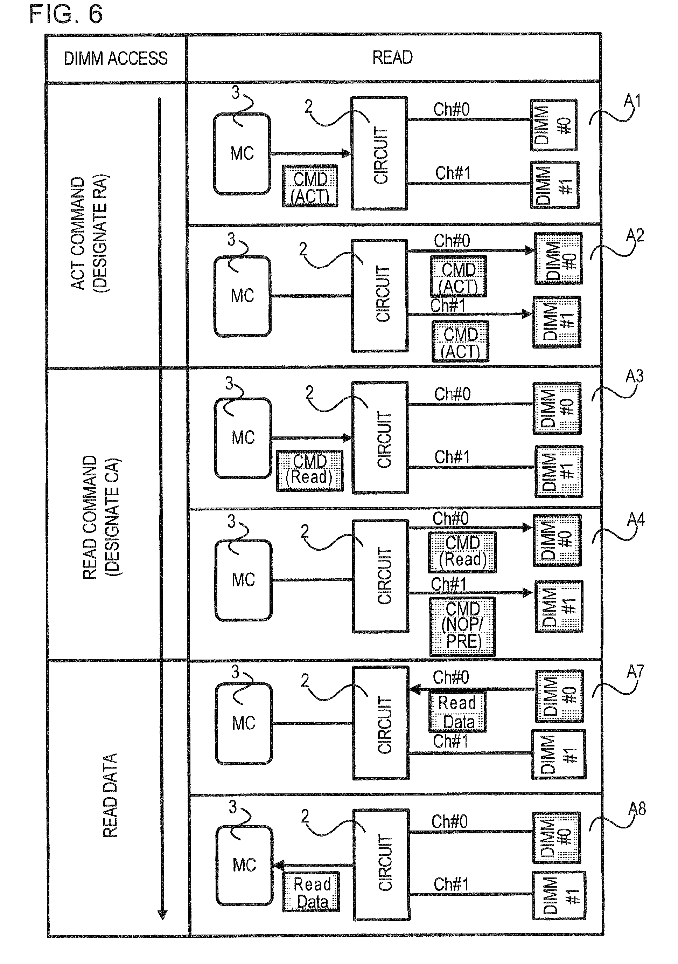

FIG. 3 is a process flow diagram of access control according to a first embodiment of the access control circuit in FIG. 1. FIG. 4 is a time chart of the process in FIG. 3. FIG. 5 is an explanation diagram of a write operation in the process of FIG. 3. FIG. 6 is an explanatory diagram of a read operation of the process of FIG. 3. Hereinafter, the control process as illustrated by FIG. 3 will be explained with reference to FIG. 4 to FIG. 6. In addition, the access control will be explained by the time-division transmission scheme of the address as described in FIG. 12.

(S10) As described in FIG.12, the memory controller 3 transmits the ACT command and the row address RA to the access control circuit 20. The access control circuit 20 in the interface circuit 2 receives the ACT command and the row address (referring A1 in FIG. 4, FIG. 5 and FIG. 6).

(S12) The access control circuit 20 transmits the ACT command to all memory modules DIMM0, DIMM 1 which has a possibility to be accessed through the command lines LC0 and LC1 when arriving the row address RA (referring A2 in FIG. 4, FIG. 5 and FIG. 6). In addition, the access control circuit 20 sends the row address to the memory modules DIMM0 and DIMM1 through the address lines LA. Both of the memory modules DIMM0 and DIMM 1 receive the ACT command and the row address (referring to A2' in FIG. 4).

(S14) As described in FIG. 12, the memory controller 3 transmits the read or write command and the column address CA to the access control circuit 20. The access control circuit 20 in the interface circuit 2 receives the read or write command and the column address CA (referring A3 in FIG. 4, FIG. 5 and FIG. 6). The access control circuit 20 determines the memory module to be accessed from the column address after arrival of the column address CA (for example, the DIMM 0 in FIG.4, FIG.5 and FIG.6).

(S16) And the access control circuit 20 sends the read or write command to determined memory module DIMM 0 (referring to A4 in FIG.4, FIG. 5 and FIG. 6). In addition, the access control circuit 20 sends the column address to the memory modules DIMM0 and DIMM 1 through the address line LA. The memory module DIMM0 receives the read or write command and the column address (A4' in FIG. 4). By this operation, the memory module DIMM0 executes the operation of read or write.

(S18) Further, the access control circuit 20 sends NOP (Not Operation) command or PRE (Preparation) command to the memory module DIMM1 which was determined to not be accessed by the access control circuit 20 (referring to A4 in FIG. 4, FIG. 5 and FIG. 6). The memory module DIMM1 receives the NOP or PRE command (referring to A4' in FIG. 4). By this operation, the memory module DIMM1 is cancelled the execution of the Act command received at step S12.

Further, the access control circuit sends the NOP command to the memory module when sending a command including a existence of auto-precharge in step S12, and sends the PRE command to the memory module when sending a command including nothing of the auto-precharge.

(S20) The access control circuit 20 receives the write data from the memory controller 3 when the command from the memory controller 3 is a write command (referring to A5 in FIG. 5). The access control circuit 20 transmits the write data to the memory module DIMM 0 to be accessed (referring to A6 in FIG.5).

(S22) On the other hand, the access control circuit 20 receives the read data from the memory module DIMM0 to be accessed, when the command from the memory controller 3 is a read command (referring to A7 in FIG. 6). The access control circuit 20 transmits the read data to the memory controller 3 which accessed (referring to A8 in FIG.6).

As illustrated in the case of transmission example of the interface circuit 2 and reception example of the memory module DIMM0 in the prior art of Figure 4, even though the interface circuit 2 receives the ACT command and the row address RA from the memory controller 3, it is not possible to determine to issue which memory modules DIMM0 or DIMM 1 until reception of the column address CA. Therefore, the interface circuit 2, after receiving the column address, sends the ACT command and the row address RA to the memory module, then sends the read or write command and the column address CA to the memory module.

On the other hand, in the embodiment, the interface circuit 20 performs a speculative access to all memory modules which has a possibility to be accessed. Thus, the interface circuit 20 sends the command of the row address to the memory module before arrival of the column address. Then, the interface circuit 20 issue the column address of the read or write command to the target memory module, after arriving the column address CA and determining the specified memory module.

In addition, the interface circuit 20 issues a command of the column address of NOP or PRE to the memory module of out of target. By the NOP or PRE command, the memory module of out of target is controlled so that there is no access from the beginning. By issuing the speculative access, even in the case that determination of selection of the memory module is made using the column address, it is possible to access the memory module without increase in the latency of the memory module. In other words, in the virtual memory system, it is possible to reduce the latency between the memory controller and memory modules and to prevent performance degradation.

### (Second embodiment of the memory system)

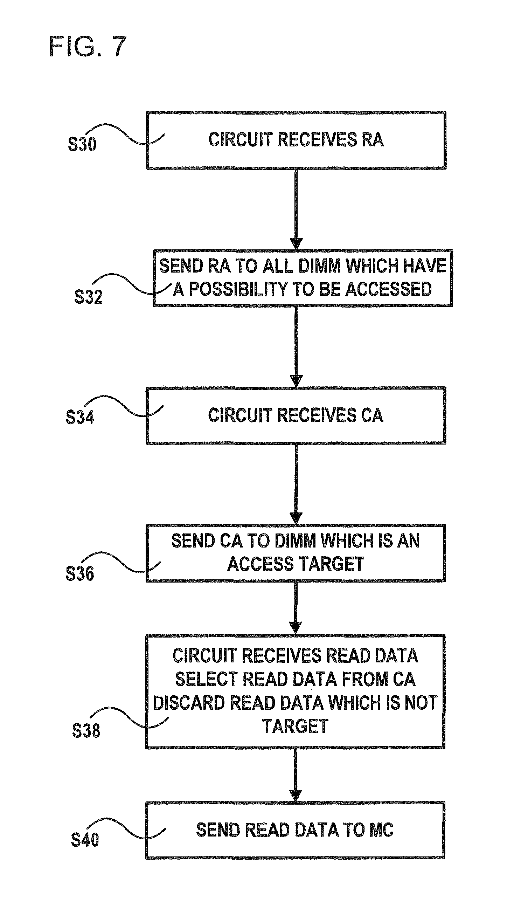

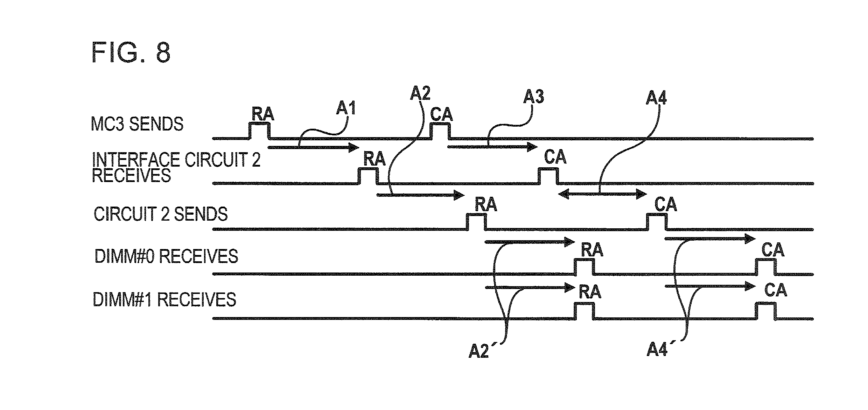

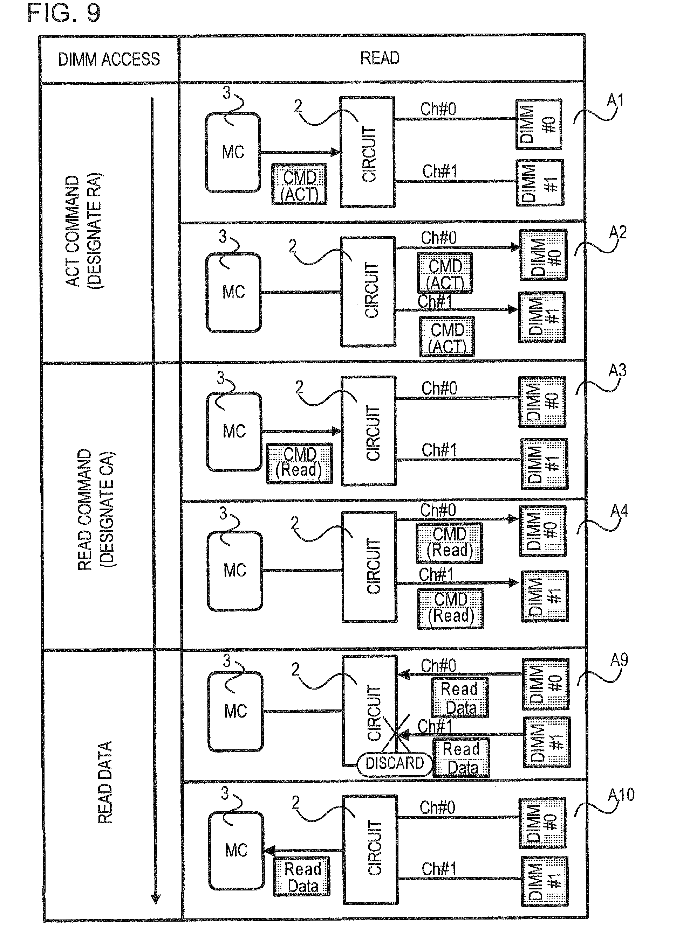

FIG. 7 is a process flow diagram of the access control according to the second embodiment of the access control circuit of FIG. 1. FIG. 8 is a time chart of the processing of FIG. 7. FIG. 9 is an explanatory diagram of a read operation of the process of FIG. 7. Hereinafter, the control process illustrated in FIG. 7 will be explained with reference to FIG. 8 and FIG.9. In addition, the access control will be explained in a time-division transmission scheme described in FIG. 12.

(S30) As described in FIG. 12, the memory controller 3 transmits the ACT command and the row address to the access control circuit 20. The access control circuit 20 in the interface circuit 2 receives the ACT command and the row address RA (referring to A1 in FIG. 8 and FIG. 9).

(S32) The access control circuit 20 transmits the ACT command to all memory modules DIMM0, DIMM 1 which has a possibility to be accessed through the command lines LC0 and LC1 when arriving the row address RA (referring A2 in FIG. 8 and FIG. 9). In addition, the access control circuit 20 sends the row address to the memory modules DIMM0 and DIMM1 through the address lines LA. Both of the memory modules DIMM0 and DIMM 1 receive the ACT command and the row address (referring to A2' in FIG. 8).

(S34) As described in FIG. 12, the memory controller 3 transmits the read command and the column address CA to the access control circuit 20. The access control circuit 20 in the interface circuit 2 receives the read command and the column address CA (referring A3 in FIG. 8 and FIG. 9). The access control circuit 20 determines the memory module to be read target from the column address after arrival of the column address CA (for example, the DIMM 0 in FIG.8 and FIG.9).

(S36) And the access control circuit 20 sends the read command all memory modules DIMM 0 and DIMM 1 which has a possibility to be accessed (referring to A4 in FIG.8 and FIG. 9). In addition, the access control circuit 20 sends the column address to the memory modules DIMM0 and DIMM 1 through the address line LA. The memory modules DIMM0 and DIMM 1 receive the read command and the column address (A4' in FIG. 8). By this operation, the memory modules DIMM0 and DIMM 1 execute the operation of read.

The access control circuit 20 receives the read data from the memory modules DIMM0 and DIMM1 which are sent the read command (referring to A9 in FIG.9). And the access control circuit 20 transmits the read data from the memory module DIMM 0 which is the read target determined in the step S34 to the memory controller 3 (referring to A10 in FIG. 9). On the other hand, the access control circuit 20 discards the read data from the memory module DIMM0 to not be a read target determined in the step S34 described above.

In the second embodiment, the access control circuit 20 performs the speculative access for all memory modules which has a possibility of access, and receives the column address CA, then receives the read data from the memory module identified and sends the read data to the memory controller 3.

In this way, Even though identifying a real memory module by the column address CA, it is possible to reduce the delay (latency) of memory access. In addition, since the interface circuit 20 which is provided separately from the memory controller 3 performs the operation, it is possible to achieve the operation without changing the memory controller having a complex function.

### (Other embodiments)

In the embodiment described above, the access control circuit 20 in the interface circuit 2 has been described to implemented by a micro-controller, however, the access control circuit 20 may be applied to compose of a discrete circuit having an address conversion circuit and a command control circuit, for example. And the memory circuit has been described in the DIMM, the memory circuit may be applied to a memory module circuit of other configurations. In addition, the DIMM may be applied to any memory circuits of the buffer type in which at least address line connects in a daisy chain.

In addition, the time-division address/command transmission method has been described in cases of DDR3, however the time-division address/command transmission method may be applied to other time-division address/command transmission method such as DDR, DDR2. Moreover, the number of memory circuits in the memory system is two, however the number of memory circuits in the memory system may be applied to three or more.

The foregoing has described the embodiments of the present invention, but within the scope of the spirit of the present invention, the present invention is able to various modifications, and it is not intended to exclude them from the scope of the present invention.

### INDUSTRIAL APPLICABILITY

An access control circuit, which receives the row address and the column address in time division and designates one among a plurality of memory circuits, performs a speculative access to the plurality of memory circuits when receiving the row address and accesses one memory circuit which is designated by the column address and sends a third command that cancel the speculative access to other memory circuits that is not designated by the column address when receiving the column address and the second command which outsets the speculative access to the memory circuit which is out of access target after receiving the column address. Therefore, because the memory circuit out of the access is controlled that was not accessed from the beginning, it is possible to reduce the delay (latency) of the memory access. In the case of a read access, because the read data from the designated memory circuit is received and the read data from the memory circuit which is not designated is discarded, it is possible to reduce the delay (latency) of memory access.

### EXPLANATION OF REFERENCES

1: memory circuit
2: interface circuit
3: memory controller
10-0 - 10-3: bank control circuit
12-0 - 12-3: memory bank
20: access control circuit
LA: address line
LC0, LC1: command line
LD0 LD1: data line

## Claims

1. Memory system comprising;
a plurality of memory circuits (DIMM0, 1); and
an access control circuit (20) that receives a row address (RA) and a first command, then receives a column address (CA) and a second command from a memory access source (3) and identifies a designated one memory circuit among the plurality of memory circuits (DIMM0, 1) by the column address received, performs an access control to the designated one memory,
wherein the access control circuit (20) performs a speculative access to the plurality of memory circuits (DIMM0, 1) when receiving the row command (RA) and the first command and sends the second command the designated one memory circuit by the column address (CA) and sends a third command that cancel the speculative access to other memory circuits that is not designated by the column address (CA) when receiving the column address (CA) and the second command.

2. Memory system comprising;
a plurality of memory circuits (DIMM0, 1); and
an access control circuit (20) that receives a row address (RA) and a first command, then receives a column address (CA) and a second command from a memory access source (3) and identifies a designated one memory circuit among the plurality of memory circuits (DIMM0, 1) by the column address (CA) received,
wherein the access control circuit (20) performs a speculative access to the plurality of memory circuits (DIMM0, 1) when receiving the row command (RA) and the first command and sends the second command to the plurality of memory circuits (DIMM0, 1) when receiving the column address (CA) and the second command and discards read data from a memory circuit that is not designated by the column address among the plurality of memory circuits (DIMM0, 1).

3. The memory system according to claim 1, wherein the access control circuit (20) sends ACT command as the first command to the plurality of memory circuits (DIMM0, 1) when receiving the row address (RA) and the first command, then receives the column address (CA) and a read or write command as the second command and identifies the designated one memory circuit among the plurality of memory circuits (DIMM0, 1) by the column address (CA) received, sends the read or write command to the designated one memory, and sends a third command that cancel the speculative access to other memory circuits that is not designated by the column address (CA).

4. The memory system according to claim 3, wherein the access control circuit (20) sends a speculative command to cancel the ACT command to the other memory circuits that is not designated by the column address (CA).

5. The memory system according to claim 1, wherein the access control circuit (20) connects to the plurality of memory circuits (DIMM0, 1) via a common address line (LA) and connects to the plurality of memory circuits (DIMM0, 1) via a separate command and data line (LC0∼LC1, LD0∼LD1).

6. The memory system according to claim 1, wherein the plurality of memory circuits (DIMM0, 1) comprising a plurality of memory module circuits.

7. The memory system according to claim 1, wherein the access control circuit (20) performs the access control to the plurality of memory circuits (DIMM0, 1) via an interface of specification DDR (Double Data Rate).

8. The memory system according to claim 2, wherein the access control circuit (20) sends the ACT command to the plurality of memory circuits (DIMM0, 1) when receiving the row address (RA) and the first command and sends the read command to the plurality of memory circuits (DIMM0, 1) when receiving the column address (CA) and the read command and the sends the read data from the designated one memory circuits among the read data received from the plurality of memory circuits (DIMM0, 1), and discards the read data from the other memory circuit which is not designated by the column address (CA).

9. The memory system according to claim 2, the access control circuit (20) connects to the plurality of memory circuits (DIMM0, 1) via a common address line (LA) and connects to the plurality of memory circuits (DIMM0, 1) via a separate command and data line (LC0∼LC1, LD0∼LD1).

10. A memory interface circuit (2) comprising:
an access control circuit (20) that is connected to a plurality of memory circuits (DIMM0, 1) and receives a row address (RA) and a first command, then receives a column address (CA) and a second command from a memory access source (3) and identifies a designated one memory circuit among the plurality of memory circuits (DIMM0, 1) by the column address (CA) received, performs an access control to the designated one memory,
wherein the access control circuit (20) performs a speculative access to the plurality of memory circuits (DIMM0, 1) when receiving the row command (RA) and the first command and sends the second command the designated one memory circuit by the column address (CA) and sends a third command that cancel the speculative access to other memory circuits that is not designated by the column address (CA) when receiving the column address (CA) and the second command.

11. A memory interface device (2) comprising;
an access control circuit (20) that is connected to a plurality of memory circuits (DIMM0, 1) and receives a row address (RA) and a first command, then receives a column address (CA) and a second command from a memory access source (3) and identifies a designated one memory circuit among the plurality of memory circuits (DIMM0, 1) by the column address (CA) received,
wherein the access control circuit (20) performs a speculative access to the plurality of memory circuits (DIMM0, 1) when receiving the row command (RA) and the first command and sends the second command to the plurality of memory circuits (DIMM0, 1) when receiving the column address (CA) and the second command and discards read data from a memory circuit that is not designated by the column address (CA) among the plurality of memory circuits (DIMM0, 1).

12. The memory interface device (2) according to claim 10, wherein the access control circuit (20) sends ACT command as the first command to the plurality of memory circuits (DIMM0, 1) when receiving the row address (RA) and the first command, then receives the column address (CA) and a read or write command as the second command and identifies the designated one memory circuit among the plurality of memory circuits (DIMM0, 1) by the column address (CA) received, sends the read or write command to the designated one memory, and sends a third command that cancel the speculative access to other memory circuits that is not designated by the column address.

13. The memory interface device (2) according to claim 11, wherein the access control circuit (20) sends a speculative command to cancel the ACT command to the other memory circuits that is not designated by the column address (CA).

14. The memory interface device (2) according to claim 10, wherein the access control circuit (20) connects to the plurality of memory circuits (DIMM0, 1) via a common address line (LA) and connects to the plurality of memory circuits via a separate command and data line (LC0∼LC1, LD0∼LD1).

15. The memory interface device (2) according to claim 10, wherein the plurality of memory circuits (DIMM0, 1) comprising a plurality of memory module circuits.

16. The memory interface device (2) according to claim 10, wherein the access control circuit (20) performs the access control to the plurality of memory circuits (DIMM0, 1) via an interface of specification DDR (Double Data Rate).

17. The memory interface device (2) according to claim 11, wherein the access control circuit (20) sends the ACT command to the plurality of memory circuits (DIMM0, 1) when receiving the row address (RA) and the first command and sends the read command to the plurality of memory circuits (DIMM0, 1) when receiving the column address (CA) and the read command and the sends the read data from the designated one memory circuits among the read data received from the plurality of memory circuits (DIMM0, 1), and discards the read data from the other memory circuit which is not designated by the column address (CA).

18. The memory interface device according to claim 11, the access control circuit (20) connects to the plurality of memory circuits (DIMM0, 1) via a common address line (LA) and connects to the plurality of memory circuits (DIMM0, 1) via a separate command and data line (LC0 ∼ LC1, LD0 ∼ LD1).
